# EUROPEAN PATENT APPLICATION

(11) **EP 1 848 041 A1**
(43) Date of publication of application: **24.10.2007**
(21) Application number: 06125382.9
(22) Date of filing: 05.12.2006
(51) Int. Cl.: H01L 29/786, H01L 21/77, H01L 27/12

(54) **Amorphous silicon thin film transistor and organic light-emitting display having the same**

(30) Priority: 17.04.2006 KR 20060034673
(71) Applicant: Samsung Electronics Co., Ltd., Suwon-si, Gyeonggi-Do (KR)
(72) Inventor: Park, Jae-chul, Gyeonggi-do (KR); Park, Young-soo, Gyeonggi-do (KR); Cha, Young-kwan, Gyeonggi-do (KR)
(74) Representative: Greene, Simon Kenneth

(57) **Abstract**

An amorphous silicon thin film transistor and an organic light-emitting display device having the same are provided. The transistor includes an amorphous silicon thin film transistor portion including a gate electrode, a gate insulating layer, an amorphous silicon layer, and source/drain electrodes, all of which are formed on a substrate; and a heat generating portion for generating heat and applying the heat to the amorphous silicon layer to recover a threshold voltage.

## Description

### BACKGROUND OF THE INVENTION

The present invention relates to an amorphous silicon thin film transistor (a-Si TFT) and an organic light-emitting display device having the same.

In the field of flat panel display (FPD) devices, lightweight, and low power consumption liquid crystal display (LCD) devices have been highlighted the most. However, since a liquid crystal display device is a passive display device, there are technical constraints in brightness, contrast, viewing angle, and size. To overcome these drawbacks, a new flat panel display device is being actively developed.

A new type of flat panel display device is an organic light-emitting display device which has organic light-emitting diodes (OLEDs) arranged two-dimensionally. Because organic light-emitting display devices are a self-emissive type display device, organic light-emitting display devices have an excellent viewing angle and contrast, compared to liquid crystal display devices. In addition, since an organic light-emitting display device requires no backlight, it can be lighter, thinner, and consume less power than liquid crystal display devices. An organic light-emitting display device has additional advantages of direct low-voltage driving capability, high response speed, robustness against external shocks because of its solidity, broad temperature range, and low manufacturing cost

In a driving of organic light-emitting display device according to active matrix using a transistor as a switching device in each pixel, the same luminance is obtained with low current. Thus, a low power consumption, high definition, and large sized display device can be implemented.

An active matrix organic light-emitting display device includes a switching transistor and a transistor for driving an organic light-emitting diode.

In such an organic light-emitting display device, a driving transistor for a back-bone of the organic light-emitting device continuously operates for a long time under constant current stress. Accordingly, when an amorphous silicon thin film transistor (a-Si TFT) is used as the driving transistor, its threshold voltage continuously increases in positive direction. This degrades luminance of the organic light-emitting display device and eventually does not satisfy a lifetime requirement.

### SUMMARY OF THE INVENTION

According to an aspect of the present invention, there is provided an amorphous silicon thin film transistor comprising: an amorphous silicon thin film transistor portion including a gate electrode, a gate insulating layer, an amorphous silicon layer, and source/drain electrodes, all of which being formed on a substrate; and a heat generating portion for generating heat and applying it to the amorphous silicon layer to recover a threshold voltage.

The transistor may further include an insulating layer between the substrate and the thin film transistor portion, wherein the heat generating portion may be formed in at least a region corresponding to the amorphous silicon layer between the substrate and the insulating layer.

The thin film transistor portion may have a bottom-gate structure in which the gate electrode, the gate insulating layer, the amorphous silicon layer, and source/drain electrodes are formed on the insulating layer in this order.

The thin film transistor portion may have a top-gate structure in which the amorphous silicon layer, the source/drain electrodes, the gate insulating layer, and the gate electrode are formed on the insulating layer in this order.

The amorphous silicon layer may include a high-concentration impurity region that is formed through high-concentration impurity injection, and the source/drain electrodes are formed on the high-concentration impurity region of the amorphous silicon layer.

The heat generating portion may include a high resistive layer generating heat through Joule heating.

The high resistive layer may be formed entirely or in a locally patterned structure.

The high resistive layer may be formed of one of indium tin oxide (ITO) or indium zinc oxide (IZO).

According to another aspect of the present invention, there is provided an organic light-emitting display device comprising: a substrate; and a plurality of pixels arranged in a matrix form on the substrate, each including a switching transistor, a driving transistor, and an organic light-emitting diode, wherein: the driving transistor is an amorphous silicon thin film transistor including a gate electrode, a gate insulating layer, an amorphous silicon layer, and source/drain electrodes, all of which being formed on the substrate, and further comprises a heat generating portion for generating heat and applying it to the amorphous silicon layer of the driving transistor to recover a threshold voltage.

The device may further include an insulating layer on the substrate, wherein the heat generating portion may be formed in at least a region between the substrate and the insulating layer corresponding to the amorphous silicon layer of the driving transistor.

The driving transistor may have a bottom-gate structure in which the gate electrode, the gate insulating layer, the amorphous silicon layer, and source/drain electrodes are formed on the insulating layer in this order.

The heat generating portion may include a high resistive layer generating heat through Joule heating.

The switching transistor may be the same amorphous silicon thin film transistor as the driving transistor.

The device may further include a select line electrically connected to a gate electrode of the switching transistor; a data line electrically connected to the gate electrode of the driving transistor through source/drain electrodes of the switching transistor; a power supplying line connected to the organic light-emitting diode through the source/drain electrodes of the driving transistor; and a Joule heating line electrically connected to the heat generating portion, wherein current is applied to the heat generating portion through the Joule heating line while the organic light-emitting diode is turned off or a system having the organic light-emitting display device is powered off, and heat is generated by the heat generating portion and transferred to the amorphous silicon layer of the driving transistor, thereby recovering the threshold voltage.

The present invention provides an amorphous silicon thin film transistor in which a threshold voltage of the amorphous silicon thin film transistor is recovered by heating, and an organic light-emitting display device having the same. The transistor may operate continuously for a long time.

### BRIEF DESCRIPTION OF THE DRAWINGS

The above and other features and advantages of the present invention will become more apparent by describing in detail embodiments thereof with reference to the attached drawings in which:
FIGS. 1 and 2 are schematic cross-sectional views of amorphous silicon thin film transistors each having a bottom-gate structure according to embodiments of the present invention;
FIG. 3 is a graph illustrating a change in a threshold voltage by DC current/voltage stress and recovery of the threshold voltage by heating in an amorphous silicon thin film transistor according to an embodiment of the present invention;
FIG. 4 is an equivalent circuit diagram illustrating a schematic structure of an organic light-emitting display device according to the present invention;
FIG. 5 is a schematic cross-sectional view illustrating a major stacked structure of an organic light-emitting display device according to an embodiment of the present invention;
FIG. 6 illustrates a layout of a major structure of one pixel in an organic light-emitting display device according to an embodiment of the present invention;
FIG. 7 is a schematic cross-sectional view illustrating a major stacked structure of an organic light-emitting display device according to another embodiment of the present invention; and
FIG. 8 illustrates a layout of a major structure of one pixel in an organic light-emitting display device according to another embodiment of the present invention.

### DETAILED DESCRIPTION OF THE INVENTION

An amorphous silicon thin film transistor and an organic light-emitting display device having the same according to embodiments of the present invention will now be described more fully hereinafter with reference to the accompanying drawings,

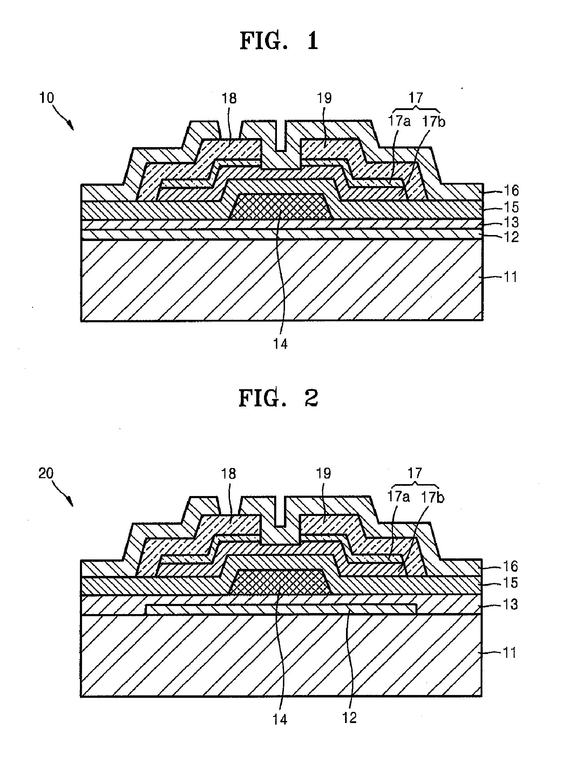

FIGS. 1 and 2 are schematic cross-sectional views of amorphous silicon thin film transistors 10 and 20 each having a bottom-gate structure according to embodiments of the present invention.

Referring to FIGS. 1 and 2, the amorphous silicon thin film transistors (a-Si TFT) 10 and 20 each having a bottom-gate structure according to embodiments of the present invention include an amorphous silicon thin film transistor portion including a gate electrode 14, a gate insulating layer 13, a gate insulating layer 15, an amorphous silicon layer 17, and source/drain electrodes 18 and 19, all of which are formed on a substrate 11; and a heat generating portion 12 for applying heat to the amorphous silicon layer 17 to recover a threshold voltage. An example of the heat generating portion 12 is a high resistive layer or a low power heating element that can be easily applied to fabricating processes. The amorphous silicon thin film transistors 10 and 20 may further include the insulating layer 13 between the substrate 11 and an amorphous silicon thin film transistor structure. The high resistive layer or the heating element may be formed at least in a region corresponding to the amorphous silicon layer 17 between the substrate 11 and the insulating layer 13.

The substrate 11 may be a glass substrate or a plastic substrate.

The high resistive layer generates heat through Joule heating. For example, the high resistive layer may be formed of indium tin oxide (ITO) or indium zinc oxide (IZO). Alternatively, the heat generating portion 12 may be formed of another material capable of effectively generating heat.

The heat generating portion 12 may be deposited on an entire surface of the substrate 11, as illustrated in FIG. 1. Alternatively, the heat generating portion 12 may be patterned to be located locally in a region corresponding to the amorphous silicon layer 17, as illustrated in FIG. 2.

The insulating layer 13 may be formed to have excellent heat preservation and thermal conductivity. For example, the insulating layer 13 may be formed of AIN or DLC (diamond-like carbon).

The amorphous silicon thin film transistor portion has a bottom-gate structure in which the gate electrode 14, the gate insulating layer 15, the amorphous silicon layer 17, and the source/drain electrodes 18 and 19 may be formed on the insulating layer 13 in this order.

The gate electrode 14 is formed in a predetermined region, and the gate insulating layer 15 is formed on the gate electrode 14 to cover the gate electrode 14.

The amorphous silicon layer 17 is formed on the gate insulating layer 15 to be located at a region including the gate electrode 14. The amorphous silicon layer 17 includes a high-concentration impurity region which is formed through high-concentration impurity injection. For example, the amorphous silicon layer 17 may include a non-impurity-doped amorphous silicon layer 17b and a heavily impurity-doped amorphous silicon layer 17a, in which a center portion of the amorphous silicon layer 17a corresponding to the gate electrode 14 is opened

The source/drain electrodes 18 and 19 are formed to be located on the heavily impurity-doped amorphous silicon layer 17a and the gate insulating layer 15. For example, the source/drain electrodes 18 and 19 are formed by forming the source/drain electrode material on an entire surface of the substrate 11 and then patterning the source/drain electrode material. In forming the source/drain electrodes 18 and 19, a portion of the heavily impurity-doped amorphous silicon layer 17a is etched to define a channel region and a source/drain electrode region.

In FIGS. 1 and 2, reference numeral 16 indicates a passivation layer for protecting the amorphous silicon thin film transistors 10 and 20. The passivation layer 16 may be formed of an insulating material.

When the amorphous silicon thin film transistors 10 and 20 according to the current embodiments of the present invention are used as driving transistors for an organic light-emitting display device, the passivation layer 16 becomes an interlayer dielectric layer. This passivation layer 16 is partially etched to form a contact hole for exposing the source/drain electrodes 18 and 19, and then electrodes of the organic light-emitting diode are formed to be electrically connected to the source/drain electrodes 18 and 19.

In this manner, according to an embodiment of the present invention, the heat generating portion 12, e.g., the high resistive layer is formed on the substrate 11, the insulating layer 13 is deposited on the heat generating portion 12, and the amorphous silicon thin film transistor portion is fabricated on the insulating layer 13.

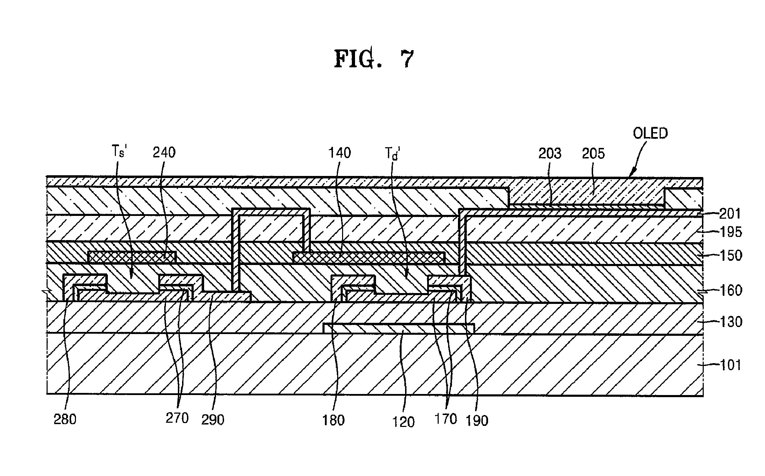

According to the current embodiments of the present invention, the amorphous silicon thin film transistors 10 and 20 are formed in a bottom-gate structure, but the amorphous silicon thin film transistors 10 and 20 of the present invention may be formed in a top-gate structure in which the amorphous silicon layer 17, the source/drain electrodes 18 and 19, the gate insulating layer 15, and the gate electrode 14 are formed on the insulating layer 13 in this order. The top-gate structure of an amorphous silicon thin film transistor will be described later with reference to FIG. 7 illustrating an organic light-emitting display device according to an embodiment of the present invention.

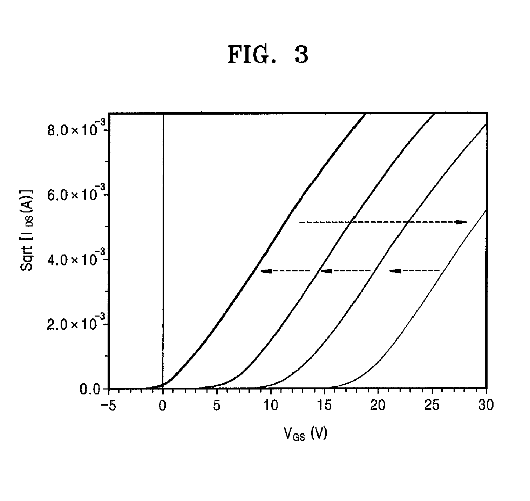

In the amorphous silicon thin film transistors 10 and 20 according to the current embodiments of the present invention as described above, when current is applied to the heat generating portion 12, e.g., the high resistive layer, heat is generated and transferred to the amorphous silicon layer 17. Accordingly, a threshold voltage of the amorphous silicon thin film transistors 10 and 20 can be recovered, as illustrated in FIG. 3.

FIG. 3 is a graph illustrating a change in a threshold voltage dependent on DC current/voltage stress and recovery of the threshold voltage in the amorphous silicon thin film transistors 10 and 20, according to an embodiment of the present invention. In FIG. 3, an arrow pointing right indicates a change in a threshold voltage due to DC current/voltage stress. Arrows pointing left indicate continuous recovery of the threshold voltage over time through heat application for a certain time.

Referring to FIG. 3, when the amorphous silicon thin film transistor 10 or 20 continuously drives, the threshold voltage continues to increase in a positive direction due to the DC current/voltage stress. The threshold voltage is recovered by applying, for a certain time, heat to the amorphous silicon layer 17 of the amorphous silicon thin film transistor 10 or 20 whose threshold voltage is increased.

The amorphous silicon thin film transistor 10 or 20 according to an embodiment of the present invention having the heat generating portion 12 as described above can be used as a driving transistor for an organic light-emitting display device that needs to operate for a long time because a threshold voltage can be recovered. Accordingly, in an organic light-emitting display device having the amorphous silicon thin film transistor 10 or 20 according to the present invention as a driving transistor, the luminance of the organic light-emitting display device can be prevented from being degraded due to an increase in the threshold voltage of the driving transistor and a lifetime requirement can be satisfied.

An organic light-emitting display device having the amorphous silicon thin film transistor 10 or 20 according to the present invention as a driving transistor will now be described.

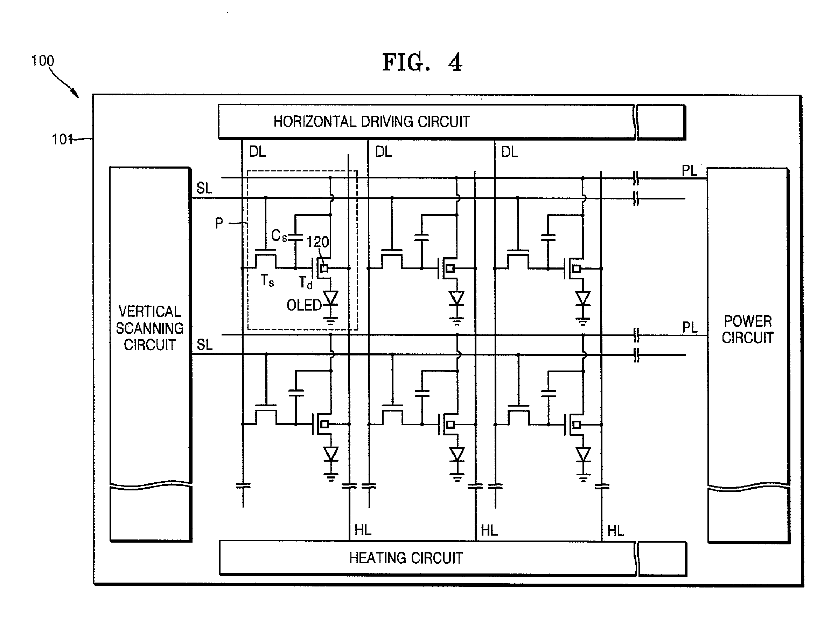

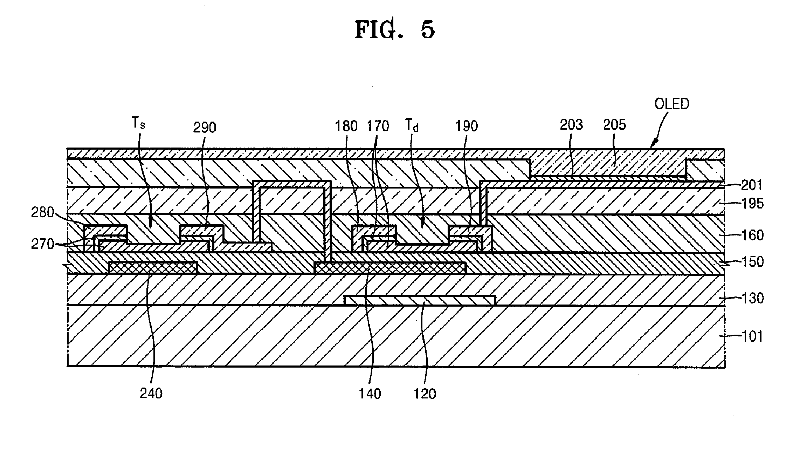

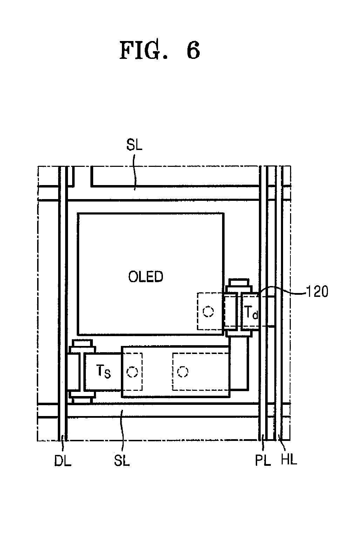

FIG. 4 is an equivalent circuit diagram illustrating a schematic structure of an organic light-emitting display device 100 according to the present invention, FIG. 5 is a schematic cross-sectional view illustrating a major stacked structure of an organic light-emitting display device according to an embodiment of the present invention, and FIG. 6 illustrates a layout of a major structure of one pixel in an organic light-emitting display device according to an embodiment of the present invention.

Referring to FIG. 4, the organic light-emitting display device 100 according to the present invention includes a substrate 101, and a plurality of pixels P arranged in a matrix form on the substrate 101, each including a switching transistor, a driving transistor Td, and an organic light-emitting diode (OLED). Each of the pixels includes a heat generating portion 120 under the driving transistor Td. For convenience of illustration, the driving transistor Td and the heat generating portion 120 are shown as separate elements. However, the heat generating portion 120 may be a part of the driving transistor Td, as in the previously-described amorphous silicon thin film transistor 10 or 20 according to an embodiment of the present invention.

Referring to FIG. 5, the substrate 101 may be a glass substrate or a plastic substrate. An insulating layer 130 may be further provided on the substrate 101. The insulating layer 130 may be formed of AIN or DLC to have excellent heat preservation and thermal conductivity.

The heat generating portion 120 is formed on the substrate 101 at a location corresponding to where the driving transistor Td is formed, and the insulating layer 130 is formed on the heat generating portion 120 to cover an entire surface of the substrate 101. A selecting and driving element layer is formed on the insulating layer 130. The selecting and driving element layer includes a switching transistor Ts and the driving transistor Td in a region of each pixel P, which is the minimum requirement for implementing a screen. An organic light-emitting diode (OLED) is formed on the selecting and driving element layer. The organic light-emitting diode has a structure in which a first electrode, an organic emission layer, and a second electrode are sequentially stacked. As a result, a matrix of the plurality of pixels P is obtained, each containing the switching transistor Ts, the driving transistor Td, and the organic light-emitting diode (OLED).

The driving transistor Td is an amorphous silicon thin film transistor as described in FIGS. 1 and 2. The switching transistor Ts may be an amorphous silicon thin film transistor. Alternatively, the switching transistor may be another type of transistor, such as a polycrystalline thin film transistor.

In FIGS. 5 and 6, both the driving transistor Td and the switching transistor Ts are amorphous silicon thin film transistors having a bottom-gate structure. When both the driving transistor Td and the switching transistor Ts are formed of the same type of amorphous silicon thin film transistor 10 or 20, they can be formed through the same process, thus simplifying a fabricating process.

The driving transistor Td and the switching transistor Ts, which are amorphous silicon thin film transistors, have gate electrodes 140 and 240, gate insulating layers 150 and 250, amorphous silicon layers 170 and 270, and source/drain electrodes 180 and 190 and 280 and 290, respectively. The gate electrodes 140 and 240, the gate insulating layers 150 and 250, the amorphous silicon layers 170 and 270, and source/drain electrodes 180 and 190 and 280 and 290 correspond to the gate electrode 14, the gate insulating layer 15, the amorphous silicon layer 17, and the source/drain electrodes 18 and 19 of the amorphous silicon thin film transistors 10 and 20 illustrated in FIGS. 1 and 2, respectively. Accordingly, descriptions thereof will be omitted.

The heat generating portion 120 is provided to transfer heat to the amorphous silicon layer 170 of the driving transistor Td to recover a threshold voltage of the driving transistor Td. The heat generating portion 120 may be patterned to be located only in a region between the substrate 101 and the insulating layer 130 corresponding to the amorphous silicon layer 170 of the driving transistor Td. Alternatively, the heat generating portion 120 may be deposited on the entire surface of the substrate 101, between the substrate 101 and the insulating layer 130.

The heat generating portion 120 may be formed of a high resistive layer or a low-power heating element that is easily applied to fabricating processes. The high resistive layer generates heat through Joule heating. For example, the high resistive layer may be formed of indium tin oxide (ITO) or indium zinc oxide (IZO). Alternatively, the heat generating portion 120 may be formed of another material capable of effectively generating heat.

A passivation layer 160 is formed on the driving transistor Td and the switching transistor Ts, and a planarized layer 195 is formed on the passivation layer 160. The passivation layer 160 may be formed of an insulating material and may serve as an interlayer insulating layer.

An organic light-emitting diode (OLED) is formed on the planarized layer 195. The organic light-emitting diode may include a first electrode 201 as an anode, an organic emission layer 203, and a second electrode 205 as a cathode.

The drain electrode 290 of the switching transistor Ts and the gate electrode 140 of the driving transistor Td are electrically connected to each other, and the drain electrode 190 of the driving transistor Td and the first electrode 201 of the organic light-emitting diode (OLED) are electrically connected to each other. For this, contact holes are formed for example in the passivation layer 160 and the planarized layer 195 to reach the drain electrode 290 of the switching transistor Ts and the gate electrode 140 and the drain electrode 190 of the driving transistor Td. And then, during forming of the first electrode 201 of the organic light-emitting diode (OLED) electrical connection between the drain electrode 290 of the switching transistor Ts and the gate electrode 140 of the driving transistor Td, and electrical connection between the drain electrode 190 of the driving transistor Td and the first electrode 201 of the organic light-emitting diode (OLED) are formed.

Referring to FIGS. 4 and 6, in the organic light-emitting display device 100 according to the present invention, the source electrode 280 of the switching transistor Ts is electrically connected to for example a data line DL, to which a data signal from a horizontal driving circuit is inputted. The data line DL is electrically connected to the gate electrode 140 of the driving transistor Td via the source/drain electrodes 280 and 290 of the switching transistor Ts. The gate electrode 240 of the switching transistor Ts is electrically connected to a select line SL, to which a select signal from a vertical scanning circuit is inputted.

The source electrode 180 of the driving transistor Td is electrically connected to a power supplying line PL, to which driving power from a power supplying circuit is supplied. The power supplying line PL is connected to the organic light-emitting diode (OLED) via the source/drain electrodes 180 and 190 of the driving transistor Td. The heat generating portion 120, e.g., high resistive layer is electrically connected to a Joule heating line HL, to which current from a heating circuit is supplied so that Joule heat is generated.

The data line DL and the select line SL are arranged to intersect with each other at right angles, thereby defining each pixel P.

Meanwhile, a portion extending from the drain electrode 290 of the switching transistor Ts and the gate electrode 140 of the driving transistor Td, which are connected to each other, and the power supplying line (PL) form a storage capacitor Cs in FIG.4.

In this manner, the heat generating portion 120, e.g., the high resistive layer is deposited on the entire surface of the substrate 101 or patterned to be located locally under the driving transistor Td, the insulating layer 130 is deposited, and then the selecting and driving element layer having the driving transistor Td and the switching transistor Ts, and the organic light-emitting diode (OLED) are formed on the insulating layer 130, thus obtaining the organic light-emitting display device 100.

In the organic light-emitting display device 100 having the above-described structure according to the present invention, the driving transistor Td that is an amorphous silicon transistor continues to operate for a long time under constant current stress applied through the power supplying line PL. Current is supplied from the heating circuit to the heat generating portion 120 through the Joule heating line HL while the organic light-emitting diode (OLED) is turned off or a system having the organic light-emitting display device 100 (e.g., a television (TV), a monitor, or a mobile device) is powered off. Accordingly, heat is generated from the heat generating portion 120 and transferred to the amorphous silicon layer 170 of the driving transistor Td, thus recovering a threshold voltage which increases when the driving transistor Td operates for a long time.

In the organic light-emitting display device 100 according to the present invention, luminance of the organic light-emitting diode (OLED) is not degraded and a lifetime requirement can be satisfied even though the amorphous silicon thin film transistor is used as the driving transistor Td.

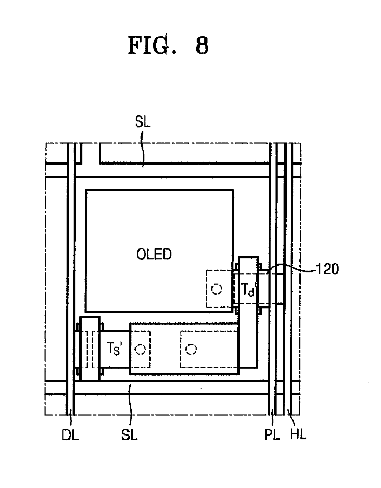

FIG. 7 is a schematic cross-sectional view illustrating a major stacked structure of an organic light-emitting display device according to another embodiment of the present invention, and FIG. 8 illustrates a layout of a major structure of one pixel in an organic light-emitting display device according to another embodiment of the present invention.

Here, elements performing the same function as in FIGS. 5 and 6 are indicated by the same reference numerals and descriptions thereof will be omitted.

Referring to FIGS. 7 and 8, an organic light-emitting display device 100 according to the present invention may include a driving transistor Td' and a switching transistor Ts' having a top-gate structure, instead of the driving transistor Td and the switching transistor Ts having a bottom-gate structure as in FIGS. 5 and 6. According to the current embodiment of the present invention, the driving transistor Td' and the switching transistor Ts' respectively include, in sequential order, amorphous silicon layers 170 and 270, source/drain electrodes 180 and 190, and 280 and 290, gate insulating layers 150 and 250, and gate electrodes 140 and 240 on the insulating layer 130. A passivation layer 160 is formed to cover the gate electrodes 140 and 240, and a planarized layer 195 is formed on the passivation layer 160. An organic light-emitting diode (OLED) is formed on the planarized layer 195 to be electrically connected to the drain electrode 190 of the driving transistor Td'.

While the amorphous silicon thin film transistors 10 and 20 according to the present invention and the organic light-emitting display device 100 having the same have been described and illustrated as including the heat generating portion 120, e.g., a high resistive layer between the substrate 101 and the insulating layer 130, the location of the heat generating portion 120 may be variously changed as long as the heat generating portion 120 can provide heat to the amorphous silicon layer of the amorphous silicon transistor or the driving transistor comprising the amorphous silicon transistor, the threshold voltage of which needs to be recovered.

As described above, according to the present invention, the threshold voltage of the amorphous silicon thin film transistor can be recovered through heat application using the heat generating portion, and thus, the amorphous silicon thin film transistor can be used as a driving transistor for an organic light-emitting display device that operates for a long time.

In the organic light-emitting display device employing the amorphous silicon thin film transistor according to the present invention as a driving transistor, the luminance of the organic light-emitting display device can be prevented from being degraded due to an increase in the threshold voltage of the driving transistor and a lifetime requirement can be satisfied.

While the present invention has been particularly shown and described with reference to embodiments thereof, it will be understood by those of ordinary skill in the art that various changes in form and details may be made therein without departing from the scope of the present invention as defined by the following claims.

## Claims

1. An amorphous silicon thin film transistor comprising:
an amorphous silicon thin film transistor portion comprising a gate electrode, a gate insulating layer, an amorphous silicon layer, and source/drain electrodes, all of which are formed on a substrate; and
a heat generating portion for generating heat and applying the heat to the amorphous silicon layer to recover a threshold voltage.

2. The transistor of claim 1, further comprising an insulating layer between the substrate and the thin film transistor portion, wherein the heat generating portion is formed in at least a region between the substrate and the insulating layer corresponding to the amorphous silicon layer.

3. The transistor of claim 2, wherein the thin film transistor portion has a bottom-gate structure in which the gate electrode, the gate insulating layer, the amorphous silicon layer, and source/drain electrodes are sequentially formed on the insulating layer.

4. The transistor of claim 3, wherein the amorphous silicon layer comprises a high-concentration impurity region that is formed through high-concentration impurity injection, and
the source/drain electrodes are formed on the high-concentration impurity region of the amorphous silicon layer.

5. The transistor of claim 2, wherein the thin film transistor portion has a top-gate structure in which the amorphous silicon layer, the source/drain electrodes, the gate insulating layer, and the gate electrode are sequentially formed on the insulating layer.

6. The transistor of claim 5, wherein the amorphous silicon layer comprises a high-concentration impurity region that is formed through high-concentration impurity injection, and
the source/drain electrodes are formed on the high-concentration impurity region of the amorphous silicon layer.

7. The transistor of one of claims 1 to 6, wherein the heat generating portion comprises a high resistive layer generating heat through Joule heating.

8. The transistor of claim 7, wherein the high resistive layer is formed entirely or in a locally patterned structure.

9. The transistor of claim 7, wherein the high resistive layer is formed of one of indium tin oxide (ITO) and indium zinc oxide (IZO).

10. An organic light-emitting display device comprising:
a substrate; and
a plurality of pixels arranged in a matrix form on the substrate, each of the pixels comprising a switching transistor, a driving transistor, and an organic light-emitting diode, wherein:
the driving transistor is an amorphous silicon thin film transistor comprising a gate electrode, a gate insulating layer, an amorphous silicon layer, and source/drain electrodes, all of which are formed on the substrate, and
further comprises a heat generating portion for generating heat and applying the heat to the amorphous silicon layer of the driving transistor to recover a threshold voltage.

11. The device of claim 10, further comprising an insulating layer on the substrate, wherein the heat generating portion is formed in at least a region between the substrate and the insulating layer corresponding to the amorphous silicon layer of the driving transistor.

12. The device of claim 11, wherein the driving transistor has a bottom-gate structure in which the gate electrode, the gate insulating layer, the amorphous silicon layer, and the source/drain electrodes are sequentially formed on the insulating layer.

13. The device of claim 12, wherein the amorphous silicon layer comprises a high-concentration impurity region that is formed through high-concentration impurity injection, and
the source/drain electrodes are formed on the high-concentration impurity region of the amorphous silicon layer.

14. The device of claim 11, wherein the driving transistor has a top-gate structure in which the amorphous silicon layer, the source/drain electrodes, the gate insulating layer, and the gate electrode are sequentially formed on the insulating layer.

15. The device of claim 14, wherein the amorphous silicon layer comprises a high-concentration impurity region that is formed through high-concentration impurity injection, and
the source/drain electrodes are formed on the high-concentration impurity region of the amorphous silicon layer.

16. The device of any one of claims 10 to 15, wherein the heat generating portion comprises a high resistive layer generating heat through Joule heating.

17. The device of claim 16, wherein the high resistive layer is formed of one of ITO and IZO.

18. The device of any one of claims 10 to 15, wherein the switching transistor is the same amorphous silicon thin film transistor as the driving transistor.

19. The device of claim 16, further comprising:
a select line electrically connected to a gate electrode of the switching transistor;
a data line electrically connected to the gate electrode of the driving transistor through source/drain electrodes of the switching transistor;
a power supplying line connected to the organic light-emitting diode through the source/drain electrodes of the driving transistor; and
a joule heating line electrically connected to the heat generating portion, wherein:
current is applied to the heat generating portion through the joule heating line while the organic light-emitting diode is turned off or a system having the organic light-emitting display device is powered off, and heat is generated by the heat generating portion and transferred to the amorphous silicon layer of the driving transistor, thereby recovering the threshold voltage.

20. The device of any one of claims 10 to 15, further comprising a gate electrode, and source/drain electrodes,
a select line electrically connected to a gate electrode of the switching transistor;
a data line electrically connected to the gate electrode of the driving transistor through source/drain electrodes of the switching transistor;
a power supplying line connected to the organic light-emitting diode through the source/drain electrodes of the driving transistor; and
a joule heating line electrically connected to the heat generating portion, wherein:
current is applied to the heat generating portion through the joule heating line while the organic light-emitting diode is turned off or a system having the organic light-emitting display device is powered off, and heat is generated by the heat generating portion and transferred to the amorphous silicon layer of the driving transistor, thereby recovering the threshold voltage.
